# EUROPEAN PATENT APPLICATION

(11) **EP 4 697 908 A1**
(43) Date of publication of application: **18.02.2026**
(21) Application number: 23941175.4
(22) Date of filing: 26.07.2023
(51) Int. Cl.: H10K 30/50

(54) **COMPOSITE TRANSPORT LAYER AND PEROVSKITE SOLAR CELL, AND PREPARATION METHOD THEREFOR**

(30) Priority: 14.06.2023 CN 202310711396
(71) Applicant: Hangzhou Microquanta Semiconductor Corporation Limited, Hangzhou, Zhejiang 311121 (CN)
(72) Inventor: YAN, Buyi, Hangzhou, Zhejiang 311121 (CN); YAO, Jizhong, Hangzhou, Zhejiang 311121 (CN); GU, Nannan, Hangzhou, Zhejiang 311121 (CN)
(74) Representative: Dai, Simin
(86) International application number: PCT/CN2023/109241
(87) International publication number: WO 2024/254949

(57) **Abstract**

This application relates to a composite transport layer, a perovskite solar cell, and a method for preparation thereof. The composite transport layer comprises a transition layer, a hole transport layer, and a buffer layer sequentially stacked along a light incident direction. A preparation material of the transition layer is NiₓA_{y}Si_{z}SnₘOₙ or CuₓA_{y}Si_{z}SnₘOₙ, x>0, y ≥ 0, z≥0, m≥0, n>0, A is aluminum (Al) or boron (B), and the preparation material of the transition layer at least includes any one of A, silicon (Si), or tin (Sn); a preparation material of the hole transport layer is any one of NiOₓ, CuₓO, or CuSCN; and a preparation material of the buffer layer is NiₐE_{b}N_{c}O_{d} or CuₐE_{b}N_{c}O_{d}, a >0, b≥0, c >0, d≥0, and E is any one of Al, B, Si, zinc (Zn), cobalt (Co), or zirconium (Zr). By adopting the composite transport layer, the perovskite solar cell in this application retains the high defect density and high hole mobility of a hole transport material, and enables the perovskite solar cell comprising the composite transport layer to achieve both high power conversion efficiency and long-term photo-thermal stability.

## Description

### TECHNICAL FIELD

This application belongs to a technical field of preparation of a perovskite solar cell, and in particular, to a composite transport layer, a perovskite solar cell, and a method for preparation thereof.

### BACKGROUND

Perovskite solar cells typically adopt either a conventional N-I-P device structure or an inverted P-I-N device structure. The conventional device at least includes, in sequence from a light incident surface: a transparent conductive layer, an electron transport layer (ETL), a perovskite active layer, a hole transport layer (HTL), and a back electrode. In contrast, the inverted device includes, in sequence from a light incident surface: a transparent conductive layer, a hole transport layer, a perovskite active layer, an electron transport layer, and a back electrode. Compared with the conventional device, the inverted device does not require the use of TiO₂, which exhibits high photocatalytic activity, or expensive hole transport materials such as Spiro-OMeTAD, which can be fabricated at low temperatures, with a simpler process and better stability. Nevertheless, currently, the high power conversion efficiencies are mostly achieved by conventional devices, with the highest efficiency reaching 26%, while the efficiencies of inverted devices are mostly in a range of 22% to 24%. Further optimization of the hole transport layer and interface in inverted devices is critical to improving the power conversion efficiency.

The relatively low power conversion efficiency of inverted devices is mainly due to the energy band mismatch at a first interface between the transparent conductive layer and the hole transport layer, and the numerous interfacial defects at a second interface between the hole transport layer and the perovskite active layer. The preparation materials of the hole transport layer are generally divided into three categories: 1) inorganic oxides or inorganic salts, 2) organic polymers, and 3) organic small molecules. Typical options for the first category of inorganic oxides or inorganic salts include NiOₓ, V₂O₅, CuO, and CuSCN; typical options for the second category of organic polymers include P3HT and PTAA; and typical options for the third category of organic small molecules include spiro-OMeTAD and self-assembled monolayer materials such as PAC_{z}. Materials of the first category are easy to obtain and low-cost; however, their good hole transport performance arises from intrinsic defects in the materials. Typically, a higher defect density is required to achieve better hole transport performance, but such a high defect density tends to degrade the photo-thermal stability at the second interface between the hole transport layer and the perovskite active layer. As a result, it is difficult to simultaneously achieve both high power conversion efficiency and good stability. Taking nickel oxide (NiOₓ) as an example, to improve its hole mobility, it is necessary to increase the concentration of under-coordinated Ni³⁺ ions. However, a high concentration of Ni³⁺ also serves as the source that promotes photocatalytic reactions at the interface between NiOₓ and the perovskite active layer. Materials of the second category generally require longer synthesis routes and exhibit better hole transport performance, making it easier to achieve high-efficiency inverted devices. However, their main drawback lies in the poor photostability of the polymer materials themselves, which tend to decompose under prolonged outdoor illumination, resulting in rapid performance degradation of the inverted devices. Materials of the third category can further improve the power conversion efficiency of inverted devices based on the material of the second category. However, similar to the materials of the second category, due to the use of organic components, their stability under prolonged illumination is poor. To address these issues, there have also been reports of using composite structures combining inorganic and organic hole transport layers, or employing methods to passivate the inorganic hole transport layers. However, using a composite structure of inorganic and organic hole transport layers is merely a palliative solution, as the organic layer still decomposes under prolonged illumination, ultimately negating the effect of the composite structure. Passivating the inorganic hole transport layer, also considered a temporary compromise, often improves stability at the cost of reduced power conversion efficiency.

Besides, existing materials for preparing the hole transport layer are generally inorganic oxides. The hole transport layer of inorganic oxides presents the following issues: the structure formed by inorganic oxides may be overly dense, leading to difficulties in hole transport; inorganic nanocrystals are prone to aggregation during long-term operation due to charge imbalance caused by surface defects, which compromises material stability once aggregation occurs; and the surface of the inorganic interface contains numerous disordered dangling bonds, some of which may react with the perovskite material.

In summary, existing hole transport layers do not enable perovskite solar cells to combine high power conversion efficiencies with good stability.

### SUMMARY

The technical problem to be solved in this application is to provide a composite transport layer, a perovskite solar cell, and a method for preparation thereof. On the one hand, a composite structure is used for a hole transport layer, in which a transition layer and a buffer layer are arranged on an upper surface and lower surface of the hole transport layer, respectively. Such a configuration retains the high defect density and high hole mobility of the hole transport material, significantly improving the light stability and the power conversion efficiency of the perovskite solar cell. On the other hand, a coupling agent is doped into a preparation material of the composite transport layer, thereby improving the conductivity and stability of the hole transport layer made from inorganic oxide materials. As a result, the prepared perovskite solar cell achieves both high power conversion efficiency and good stability.

This application is realized by providing a first type of composite transport layer, comprising a transition layer, a hole transport layer, and a buffer layer sequentially stacked along a light incident direction. A preparation material of the transition layer is NiₓA_{y}Si_{z}SnₘOₙ or CuₓA_{y}Si_{z}SnₘOₙ, x>0, y ≥ 0, z≥0, m≥0, n>0, A is aluminum (Al) or boron (B), and the preparation material of the transition layer at least includes any one of A, silicon (Si), or tin (Sn). A preparation material of the hole transport layer is any one of NiOₓ, CuₓO, or CuSCN. A preparation material of the buffer layer is NiₐE_{b}N_{c}O_{d} or CuₐE_{b}N_{c}O_{d}, a >0, b≥0, c >0, d≥0, and E is any one of Al, B, Si, zinc (Zn), cobalt (Co), or zirconium (Zr).

This application is realized by providing a second type of composite transport layer, comprising a transition layer, a hole transport layer, and a buffer layer sequentially stacked along a light incident direction. A preparation material of the transition layer is NiₓA_{y}Si_{z}SnₘOₙ or CuₓA_{y}Si_{z}SnₘOₙ, x>0, y ≥ 0, z≥0, m≥0, n>0, A is aluminum (Al) or boron (B), and the preparation material of the transition layer at least includes any one of A, Si, or Sn. A preparation material of the hole transport layer is any one of NiOₓ, CuₓO, or CuSCN. A preparation material of the buffer layer is NiₐE_{b}N_{c}O_{d} or CuₐE_{b}N_{c}O_{d}, a >0, b≥0, c >0, d≥0, and E is any one of Al, B, Si, Zn, Co, or Zr. The preparation material of the transition layer and/or the buffer layer is doped with a coupling agent to obtain a corresponding array transition layer and/or array buffer layer containing the coupling agent, a thin film prepared from the array transition layer and/or array buffer layer doped with the coupling agent includes a plurality of array molecular groups containing the coupling agent that are discretely arranged and a plurality of openings separating two adjacent array molecular groups among the plurality of array molecular groups, and each of the plurality of opening communicates an upper surface and lower surface of the thin film in which it is located, respectively. The coupling agent is any one of a silane coupling agent, a titanate coupling agent, an aluminate coupling agent, a phosphate coupling agent, or a borate coupling agent.

This application is realized by providing a first type of perovskite solar cell. An internal structure of the perovskite solar cell comprises a transparent conductive layer, a perovskite light-absorbing layer, an electron transport layer, and a back electrode stacked sequentially. The composite transport layer is arranged between the transparent conductive layer and the perovskite light-absorbing layer, a transition layer of the composite transport layer is in conformal contact with the transparent conductive layer, and a buffer layer of the composite transport layer is in conformal contact with the perovskite light-absorbing layer.

This application is realized by providing a second type of perovskite solar cell. An internal structure of the perovskite solar cell comprises a transparent conductive layer, a perovskite light-absorbing layer, an electron transport layer, and a back electrode stacked sequentially. The composite transport layer is arranged between the transparent conductive layer and the perovskite light-absorbing layer, a transition layer of the composite transport layer is in conformal contact with the transparent conductive layer, and a buffer layer of the composite transport layer is in conformal contact with the perovskite light-absorbing layer.

This application is realized by providing a method for preparing the first type of perovskite solar cell, comprising:
step 1, cleaning and performing ultraviolet ozone treatment on the transparent conductive layer;
step 2, preparing the transition layer on the transparent conductive layer in a vapor phase manner or a liquid phase manner, wherein the vapor phase manner is to prepare the transition layer using any one of an atomic layer deposition (ALD) device, a chemical vapor deposition (CVD) device, a magnetron sputtering device, an electron-beam evaporation device, or a thermal evaporation device, and the liquid phase manner is to prepare the transition layer by any one of a solution mixing manner, a hydrothermal manner, a chemical bath deposition (CBD) manner, or an in-situ doping manner;
step 3, preparing the hole transport layer on the transition layer using any one of the ALD device, the CVD device, the magnetron sputtering device, the electron-beam evaporation device, or the thermal evaporation device, or preparing the hole transport layer by any one of blade coating, slot-die coating, or spray coating;
step 4, preparing the buffer layer on the hole transport layer in the vapor phase manner or the liquid phase manner, wherein the vapor phase manner is to prepare the buffer layer using any one of the ALD device, the CVD device, the magnetron sputtering device, the electron-beam evaporation device, or the thermal evaporation device, and the liquid phase manner is to prepare the buffer layer by any one of the solution mixing manner, the hydrothermal manner, the CBD manner, or the in-situ doping manner; and
step 5, preparing the perovskite light-absorbing layer, the electron transport layer, and the back electrode on the buffer layer sequentially until preparation of the perovskite solar cell is completed.

This application is realized by providing a method for preparing the second type of perovskite solar cell, comprising:
step I, cleaning and performing ultraviolet ozone treatment on the transparent conductive layer;
step II, obtaining a first composite precursor solution by mixing the coupling agent with a material solution for preparing the transition layer, performing ultraviolet irradiation treatment or high-temperature treatment on the first composite precursor solution, and then coating the treated first composite precursor solution on the transparent conductive layer, and annealing and drying the treated first composite precursor solution on the transparent conductive layer to obtain an array transition layer;
step III, preparing the hole transport layer on the transition layer using any one of an ALD device, a CVD device, a magnetron sputtering device, an electron-beam evaporation device, or a thermal evaporation device, or preparing the hole transport layer by any one of blade coating, slot-die coating, or spray coating;
step IV, preparing the buffer layer on the hole transport layer in a vapor phase manner or a liquid phase manner, wherein the vapor phase manner is to prepare the buffer layer using any one of the ALD device, the CVD device, the magnetron sputtering device, the electron-beam evaporation device, or the thermal evaporation device, and the liquid phase manner is to prepare the buffer layer by any one of a solution mixing manner, a hydrothermal manner, a CBD manner, or an in-situ doping manner; and
step V, preparing the perovskite light-absorbing layer, the electron transport layer, and the back electrode on the buffer layer sequentially until preparation of the perovskite solar cell is completed.

This application is realized by providing a method for preparing the second type of perovskite solar cell, comprising:
step 1, cleaning and performing ultraviolet ozone treatment on the transparent conductive layer;
step 2, preparing the transition layer on the transparent conductive layer in a vapor phase manner or a liquid phase manner, wherein the vapor phase manner is to prepare the transition layer using any one of an ALD device, a CVD device, a magnetron sputtering device, an electron-beam evaporation device, or a thermal evaporation device, and the liquid phase manner is to prepare the transition layer by any one of a solution mixing manner, a hydrothermal manner, a CBD manner, or an in-situ doping manner;
step 3, preparing the hole transport layer on the transition layer using any one of the ALD device, the CVD device, the magnetron sputtering device, or the electron-beam evaporation device, and the thermal evaporation device, or preparing the hole transport layer on the transition layer by any one of blade coating, slot-die coating, or spray coating;
step 4, obtaining a second composite precursor solution by mixing the coupling agent with a material solution for preparing the buffer layer, performing ultraviolet irradiation treatment or high-temperature treatment on the second composite precursor solution, and then coating the treated second composite precursor solution on the hole transport layer, and annealing and drying the treated second composite precursor solution on the hole transport layer to obtain an array buffer layer; and
step 5, preparing the perovskite light-absorbing layer, the electron transport layer, and the back electrode on the buffer layer sequentially until preparation of the perovskite solar cell is completed.

This application is realized by providing a method for preparing the second type of perovskite solar cell, comprising:
step A: performing cleaning and ultraviolet ozone treatment on the transparent conductive layer;
step B: obtaining the first composite precursor solution by mixing the coupling agent with the material solution for preparing the transition layer, and performing the ultraviolet illumination treatment or high-temperature treatment on the first composite precursor solution, and then coating the treated first composite precursor solution on the transparent conductive layer, and annealing and drying the treated first composite precursor solution on the transparent conductive layer to obtain the buffer layer;
step C: preparing the hole transport layer on the transition layer using any one of the ALD device, the CVD device, the magnetron sputtering device, the electron-beam evaporation device, or the thermal evaporation device, or preparing the hole transport layer by any one of the blade coating, the slot-die coating, or the spray coating;
step D: obtaining the second composite precursor solution by mixing the coupling agent with the material solution for preparing the buffer layer, performing the ultraviolet illumination treatment or high-temperature treatment on the second composite precursor solution, and then coating the treated second composite precursor solution on the hole transport layer, and annealing and drying the treated second composite precursor solution on the hole transport layer to obtain the buffer layer;
step E: preparing the perovskite light-absorbing layer, the electron transport layer, and the back electrode on the buffer layer until preparation of the perovskite solar cell is completed.

This application utilizes the difference in wettability between the nanoparticles used to prepare the transition layer and/or buffer layer and a portion of the crosslinked coupling agent. During the coating and film-forming process, this difference leads to the formation of a plurality of array molecular groups containing the coupling agent that are continuously and discretely arranged and a plurality of openings separating two adjacent array molecular groups among the plurality of array molecular groups. As a result, an "array-like" transition layer and/or buffer layer containing the coupling agent is obtained.

Compared to the prior art, in the first type of composite transport layer, the perovskite solar cell, and the preparation method thereof of this application, the composite transport layer comprises a transition layer, a hole transport layer, and a buffer layer sequentially stacked along a light incident direction, and a preparation material of the transition layer is NiₓA_{y}Si_{z}SnₘOₙ or CuₓA_{y}Si_{z}SnₘOₙ, x>0, y ≥ 0, z≥0, m≥0, n>0, A is aluminum (Al) or boron (B), and the preparation material of the transition layer at least includes any one of A, silicon (Si), or tin (Sn); a preparation material of the hole transport layer is any one of NiOₓ, CuₓO, or CuSCN; and a preparation material of the buffer layer is NiₐE_{b}N_{c}O_{d} or CuₐE_{b}N_{c}O_{d}, a >0, b≥0, c >0, d≥0, and E is any one of Al, B, Si, zinc (Zn), cobalt (Co), or zirconium (Zr). A composite structure is used for the hole transport layer, in which a transition layer and a buffer layer are arranged on an upper surface and lower surface of the hole transport layer, respectively. Such a configuration retains the high defect density and high hole mobility of the hole transport material, and enables the prepared perovskite solar cell comprising the composite transport layer to achieve both high power conversion efficiency and long-term photo-thermal stability.

Compared to the prior art, in the second type of composite transport layer, the perovskite solar cell, and the preparation method thereof of this application. The composite transport layer comprises a transition layer, a hole transport layer, and a buffer layer sequentially stacked along a light incident direction. A preparation material of the transition layer is NiₓA_{y}Si_{z}SnₘOₙ or CuₓA_{y}Si_{z}SnₘOₙ, x>0, y ≥ 0, z≥0, m≥0, n>0, A is aluminum (Al) or boron (B), and the preparation material of the transition layer at least includes any one of A, Si, or Sn; a preparation material of the hole transport layer is any one of NiOₓ, CuₓO, or CuSCN; and a preparation material of the buffer layer is NiₐE_{b}N_{c}O_{d} or CuₐE_{b}N_{c}O_{d}, a >0, b≥0, c >0, d≥0, and E is any one of Al, B, Si, Zn, Co, or Zr. The preparation material of the transition layer and/or the buffer layer is doped with a coupling agent to obtain a corresponding array transition layer and/or array buffer layer containing the coupling agent, a thin film prepared from the array transition layer and/or array buffer layer doped with the coupling agent includes a plurality of array molecular groups containing the coupling agent that are discretely arranged and a plurality of openings separating two adjacent array molecular groups among the plurality of array molecular groups, and each of the plurality of opening communicates an upper surface and lower surface of the thin film in which it is located, respectively. The coupling agent is any one of a silane coupling agent, a titanate coupling agent, an aluminate coupling agent, a phosphate coupling agent, or a borate coupling agent. The hole transport layer of this application adopts a composite array structure. In addition, the preparation material of the transition layer and/or buffer layer are added and doped with the coupling agent, thereby forming an array transition layer and/or array buffer layer, which enhances the conductivity and stability of the hole transport layer made from inorganic oxide materials, thus significantly improving the light stability and the power conversion efficiency of the perovskite solar cell.

### BRIEF DESCRIPTION OF THE DRAWINGS

FIG. 1 is a schematic diagram illustrating an exemplary plan view of an internal structure of a first type of perovskite solar cell according to one optimal embodiment of this application;
FIG. 2 is a schematic diagram illustrating an exemplary plan view of a first internal structure of a second type of perovskite solar cell according to some embodiments of this application;
FIG. 3 is a schematic diagram illustrating an exemplary plan view of a second internal structure of a second type of perovskite solar cell according to some embodiments of this application;
FIG. 4 is a schematic diagram illustrating an exemplary plan view of a third internal structure of a second type of perovskite solar cell according to some embodiments of this application;
FIG. 5 is a schematic diagram illustrating a comparison of power conversion efficiency curves of a perovskite solar cell prepared in Embodiment 1 and a perovskite solar cell prepared in Comparative Example 1;
FIG. 6 is a schematic diagram illustrating a comparison of power conversion efficiency curves of a perovskite solar cell prepared in Embodiment 1 and perovskite solar cells prepared in Comparative Examples 1 and 2;
FIG. 7 is a schematic diagram illustrating a comparison of aging experiment curves of a perovskite solar cell prepared in Embodiment 1 and perovskite solar cells prepared in Comparative Examples 1, 2, and 3;
FIG. 8 is a schematic diagram illustrating an exemplary three-dimensional structure of a composite transport layer of the second internal structure of the second type of perovskite solar cell in FIG. 3;
FIG. 9 is a schematic diagram illustrating a comparison of power conversion efficiency curves of a perovskite solar cell prepared in Embodiment 5 and perovskite solar cells prepared in Comparative Examples 1, 3, and 4; and
FIG. 10 is a schematic diagram illustrating a comparison of aging experiment curves of a perovskite solar cell prepared in Embodiment 5 and perovskite solar cells prepared in Comparative Embodiments 1, 3, and 4.

### DETAILED DESCRIPTION

To make the technical problems to be solved, the technical solutions, and the beneficial effects of this application more clearly understood, the following provides a more detailed description of this application with reference to the accompanying drawings and specific embodiments. It should be understood that the specific embodiments described herein are merely intended to illustrate the present invention and are not to be construed as limiting the scope thereof.

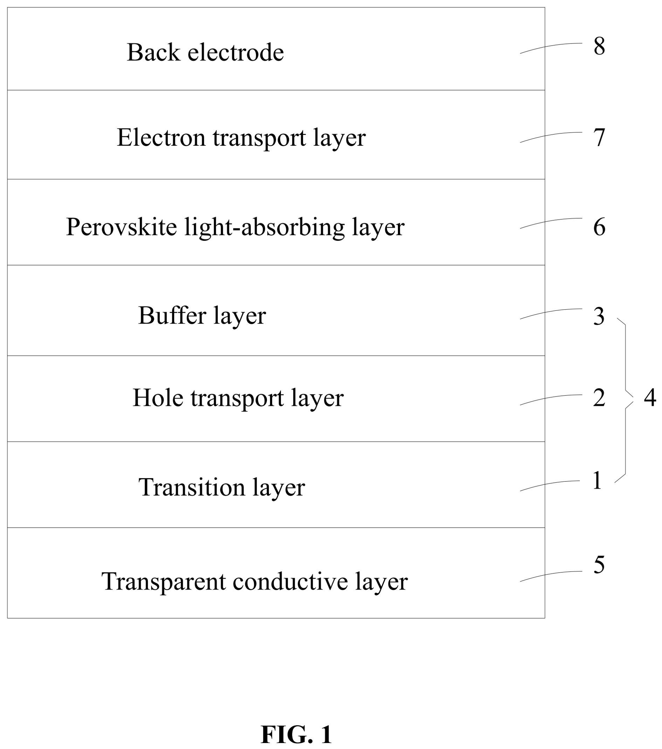

FIG. 1 is a schematic diagram illustrating an exemplary plan view of an internal structure of a first type of perovskite solar cell according to one optimal embodiment of this application. As shown in FIG. 1, a first type of composite transport layer includes a transition layer 1, a hole transport layer 2, and a buffer layer 3 sequentially stacked along a light incident direction. A preparation material of the transition layer 1 is NiₓA_{y}Si_{z}SnₘOₙ or CuₓA_{y}Si_{z}SnₘOₙ, x>0, y ≥ 0, z≥0, m≥0, and n>0, A is aluminum (Al) or boron (B), and the preparation material of the transition layer 1 at least includes any one of A, silicon (Si), or tin (Sn). A preparation material of the hole transport layer 2 is any one of nickel oxide (NiOₓ), copper oxide (CuₓO), or cuprous thiocyanate (CuSCN). A preparation material of the buffer layer 3 is NiₐE_{b}N_{c}O_{d} or CuₐE_{b}N_{c}O_{d}, a >0, b≥0, c >0, d≥0, and E is any one of Al, B, Si, zinc (Zn), cobalt (Co), or zirconium (Zr).

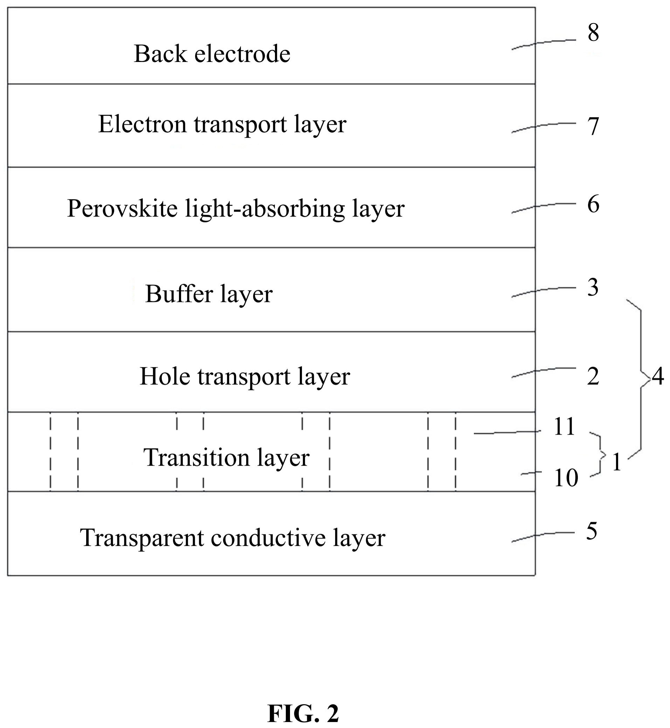

As shown in FIG. 2 to FIG. 4, a second type of composite transport layer according to one optimal embodiment of this application includes the transition layer 1, the hole transport layer 2, and the buffer layer 3 stacked sequentially along a light incident direction. A preparation material of the transition layer 1 is NiₓA_{y}Si_{z}SnₘOₙ or NiₓA_{y}Si_{z}SnₘOₙ, x > 0, y ≥ 0, z ≥ 0, m ≥ 0, and n > 0, and A is Al or B, and the preparation material of the transition layer 1 at least includes any one of A, Si, or Sn. A preparation material of the hole transport layer 2 is any one of NiOₓ, CuₓO, or CuSCN. A preparation material of the buffer layer 3 is NiₐE_{b}N_{c}O_{d} or CuₐE_{b}N_{c}O_{d}, a>0, b≥0, c>0, and d≥0, and E is any one of Al, B, Si, Zn, Co, or Zr.

The preparation material of the transition layer and/or the buffer layer is added and doped with a coupling agent to obtain a corresponding array transition layer and/or array buffer layer containing the coupling agent. A thin film prepared from the array transition layer and/or array buffer layer doped with the coupling agent includes a plurality of array molecular groups containing the coupling agent that are discretely arranged and a plurality of openings separating two adjacent array molecular groups among the plurality of array molecular groups, and each of the plurality of opening communicates an upper surface and lower surface of the thin film in which it is located. The coupling agent is any one of a silane coupling agent, a titanate coupling agent, an aluminate coupling agent, a phosphate coupling agent, or a borate coupling agent.

Specifically, the addition amount of the coupling agent is in a range of 0.5% to 5% of a volume of a corresponding nanoparticle suspension for preparing the transition layer 1 and/or the buffer layer 3, and a concentration of the nanoparticle suspension is in a range of 0.1wt.% to 10wt.%.

Specifically, the length of each of the plurality of openings 10 (i.e., an interval between two adjacent molecular groups) is in a range of 10 nm to 200 nm.

Specifically, in the first type of composite transport layer and the second type of composite transport layer of this application, the thickness of the transition layer 1 is in a range of 0.2 nm to 30 nm, the thickness of the hole transport layer 2 is in a range of 1 nm to 100 nm, and the thickness of the buffer layer 3 is in a range of 0.2 nm to 50 nm.

Referring to FIG. 1, this application provides a first type of perovskite solar cell, an internal structure of the perovskite solar cell comprises the transparent conductive layer 5, the perovskite light-absorbing layer 6, an electron transport layer 7, and a back electrode 8 stacked sequentially, and a first type of composite transport layer 4 is disposed between the transparent conductive layer 5 and the perovskite light-absorbing layer 6. The transition layer 1 of the composite transport layer 4 is in conformal contact with the transparent conductive layer 5, the buffer layer 3 of the composite transport layer 4 is in conformal contact with the perovskite light-absorbing layer 6, and the hole transport layer 2 of the composite transport layer 6 is disposed between the transition layer 1 and the buffer layer 3.

Referring to FIG. 2 to FIG. 4, this application also provides a second type of perovskite solar cell, an internal structure of the perovskite solar cell comprises the transparent conductive layer 5, the perovskite light-absorbing layer 6, the electron transport layer 7, and the back electrode 8 stacked sequentially, and the second type of composite transport layer 4 is disposed between the transparent conductive layer 5 and the perovskite light-absorbing layer 6. The transition layer 1 of the composite transport layer 4 is in conformal contact with the transparent conductive layer 5, the buffer layer 3 of the composite transport layer 4 is in conformal contact with the perovskite light-absorbing layer 6, and the hole transport layer 2 of the composite transport layer 4 is disposed between the transition layer 1 and the buffer layer 3.

In the first type of perovskite solar cell and the second type of perovskite solar cell of this application, a molecular formula of a preparation material of the perovskite light-absorbing layer 6 is ABX₃, where A is at least one cation selected from cesium, rubidium, ammonium, formamidine, and alkali metal cations; B is a divalent metal cation selected from any one of lead, tin, tungsten, copper, zinc, gallium, germanium, arsenic, selenium, rhodium, palladium, silver, cadmium, indium, antimony, osmium, iridium, platinum, gold, mercury, thallium, bismuth, or polonium; and X is an anion selected from any one of iodide, bromide, chloride, astatide, thiocyanate, or acetate.

A composite transport layer of the second type of perovskite solar cell of this application has the following features:
1. The simple formation of openings during the coating of nanoparticles addresses the issue of excessively dense inorganic oxide layer structures, eliminates the influence of the thickness of the transition layer and buffer layer on electron tunneling, and reduces non-radiative recombination at the interface between the perovskite light-absorbing layer and the hole transport layer without impairing charge carrier transport.
2. Inorganic nanocrystals are prone to aggregation during long-term use due to surface defect-induced charge imbalance, which, once aggregation occurs, can negatively affect the stability of the material. However, the adhesive and dispersive effects of the coupling agent can avoid such a phenomenon, thereby enhancing the stability of the material and the device.
3. Since a large number of disordered dangling bonds exist on the surface of inorganic interfaces, the use of the coupling agent can also passivate these surface dangling bonds, thereby suppressing photocatalytic reactions between the inorganic material and the perovskite interface, and further enhancing stability.

Referring to FIG. 1, this application also discloses a method for preparing the first type of perovskite solar cell, comprising:
step 1, cleaning and ultraviolet ozone treatment are performed on the transparent conductive layer 5.
Step 2, the transition layer 1 is prepared on the transparent conductive layer 5 in a vapor phase manner or a liquid phase manner. The vapor phase manner refers to preparing the transition layer 1 using any one of an atomic layer deposition (ALD) device, a chemical vapor deposition (CVD) device, a magnetron sputtering device, an electron-beam evaporation device, or a thermal evaporation device, and the liquid phase manner refers to preparing the transition layer 1 by any one of a solution mixing manner, a hydrothermal manner, a chemical bath deposition (CBD) manner, or an in-situ doping manner.
step 3, the hole transport layer 2 is prepared on the transition layer 1 using any one of the ALD device, the CVD device, the magnetron sputtering device, the electron-beam evaporation device, or the thermal evaporation device, or the hole transport layer 2 is prepared by any one of blade coating, slot-die coating, or spray coating.
step 4, the buffer layer 3 is prepared on the hole transport layer 2 in the vapor phase manner or the liquid phase manner. The vapor phase manner refers to preparing the buffer layer 3 using any one of the ALD device, the CVD device, the magnetron sputtering device, the electron-beam evaporation device, or the thermal evaporation device, and the liquid phase manner refers to preparing the buffer layer 3 by any one of the solution mixing manner, the hydrothermal manner, the CBD manner, or the in-situ doping manner.
step 5, the perovskite light-absorbing layer 6, the electron transport layer 7, and the back electrode 8 is sequentially prepared on the buffer layer 3 until preparation of the perovskite solar cell is completed.

Referring to FIG. 2, this application also discloses a method for preparing the second type of perovskite solar cell, comprising:
step I, cleaning and ultraviolet ozone treatment are performed on the transparent conductive layer 5.
step II: a first composite precursor solution is obtained by mixing a coupling agent with a material solution for preparing the transition layer 1, ultraviolet illumination treatment or high-temperature treatment is performed on the first composite precursor solution, and then the treated first composite precursor solution is coated on the transparent conductive layer 5, and the treated first composite precursor solution on the transparent conductive layer is annealed and dried to obtain the array transition layer 1.
step III, the hole transport layer 2 is prepared on the transition layer 1 using any one of the ALD device, the CVD device, the magnetron sputtering device, the electron-beam evaporation device, or the thermal evaporation device, or the hole transport layer 2 is prepared by any one of the blade coating, the slot-die coating, or the spray coating.
step IV, the buffer layer 3 is prepared on the hole transport layer 2 in the vapor phase manner or the liquid phase manner. The vapor phase manner refers to preparing the buffer layer 3 using any one of the ALD device, the CVD device, the magnetron sputtering device, the electron-beam evaporation device, or the thermal evaporation device, and the liquid phase manner refers to preparing the buffer layer 3 by any one of the solution mixing manner, the hydrothermal manner, the chemical bath deposition (CBD) manner, or the in-situ doping manner.
step V, the perovskite light-absorbing layer 6, the electron transport layer 7, and the back electrode 8 is sequentially prepared on the buffer layer 3 until preparation of the perovskite solar cell is completed.

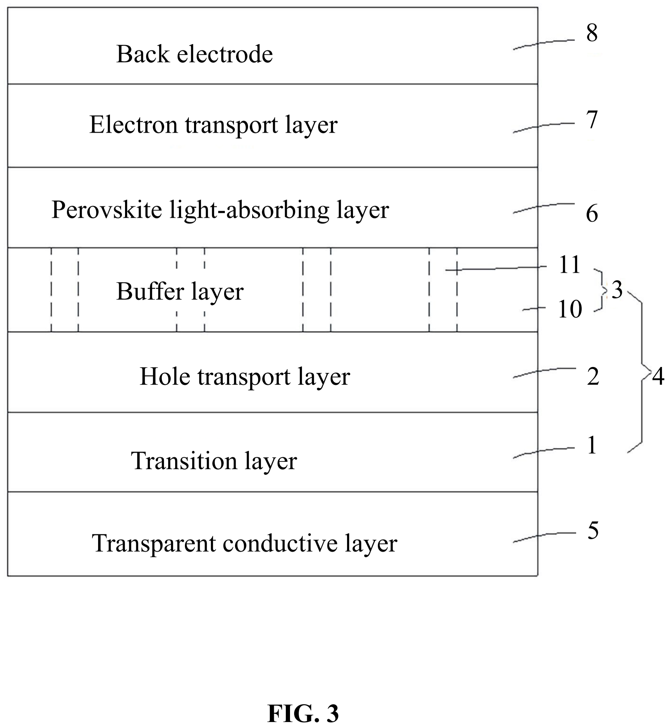

Referring to FIG. 3, this application also discloses a method for preparing the second type of perovskite solar cell, comprising:
step 1: cleaning and ultraviolet ozone treatment are performed on the transparent conductive layer 5.
step 2, the transition layer 1 is prepared on the transparent conductive layer 5 in the vapor phase manner or the liquid phase manner. The vapor phase manner refers to preparing the transition layer 1 using any one of the ALD device, the CVD device, the magnetron sputtering device, the electron-beam evaporation device, or the thermal evaporation device, and the liquid phase manner refers to preparing the transition layer 1 by any one of the solution mixing manner, the hydrothermal manner, the CBD manner, or the in-situ doping manner.
step 3, the hole transport layer 2 is prepared on the transition layer 1 using any one of the ALD device, the CVD device, the magnetron sputtering device, the electron-beam evaporation device, or the thermal evaporation device, or the hole transport layer 2 is prepared by any one of the blade coating, the slot-die coating, or the spray coating.
step 4: a second composite precursor solution is obtained by mixing a coupling agent with a material solution for preparing the buffer layer 3, ultraviolet illumination treatment or high-temperature treatment is performed on the second composite precursor solution, and then the treated second composite precursor solution is coated on the hole transport layer 2, and the treated second composite precursor solution on the hole transport layer 2 is annealed and dried to obtain the array buffer layer 3.
step 5, the perovskite light-absorbing layer 6, the electron transport layer 7, and the back electrode 8 is sequentially prepared on the buffer layer 3 until preparation of the perovskite solar cell is completed.

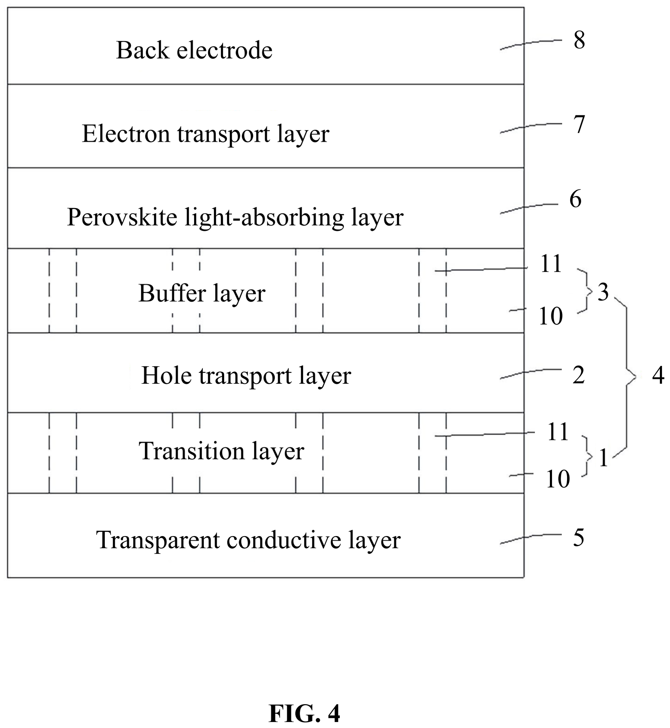

Referring to FIG. 4, this application also discloses a method for preparing the second type of perovskite solar cell, comprising:
step A: cleaning and ultraviolet ozone treatment are performed on the transparent conductive layer 5.
step B: the first composite precursor solution is obtained by mixing the coupling agent with the material solution for preparing the transition layer 1, and the ultraviolet illumination treatment or high-temperature treatment is performed on the first composite precursor solution, and then the treated first composite precursor solution is coated on the transparent conductive layer 5, and the treated first composite precursor solution on the transparent conductive layer 5 is annealed and dried to obtain the array buffer layer 1.
step C: the hole transport layer 2 is prepared on the transition layer 1 using any one of the ALD device, the CVD device, the magnetron sputtering device, the electron-beam evaporation device, or the thermal evaporation device, or the hole transport layer 2 is prepared by any one of the blade coating, the slot-die coating, or the spray coating.
step D: the second composite precursor solution is obtained by mixing the coupling agent with the material solution for preparing the buffer layer 3, the ultraviolet illumination treatment or high-temperature treatment is performed on the second composite precursor solution, and then the treated second composite precursor solution is coated on the hole transport layer 2, and the treated second composite precursor solution on the hole transport layer 2 is annealed and dried to obtain the array buffer layer 3.
step E: the perovskite light-absorbing layer 6, the electron transport layer 7, and the back electrode 8 is sequentially prepared on the buffer layer 3 until preparation of the perovskite solar cell is completed.

Specifically, a condition of the ultraviolet illumination treatment includes a light wavelength in a range of 265 nm to 365 nm and an illumination treatment duration in a range of 5 min to 60 min. A condition of the high-temperature treatment includes a heating temperature in a range of 50 °C to 100 °C and a heating duration in a range of 5 min to 60 min.

The structure of the perovskite solar cell disclosed in this application and a method for preparing the perovskite solar cell are further described below by way of specific embodiments.

### Embodiment 1

Referring to FIG. 1, an embodiment of a method for preparing a first type of perovskite solar cell according to this application is disclosed, comprising:
Step 11: a glass of the fluorine-doped tin oxide (FTO) transparent conductive layer 5 was sequentially cleaned by ultrasonic treatment for 30 min each in dishwashing detergent, deionized water, acetone, and isopropanol, and then was dried with nitrogen (N₂), and was subjected to ultraviolet ozone treatment for 10 min.
Step 12, the transition layer 1 with a thickness of 0.2 nm to 30 nm was prepared on the FTO transparent conductive layer 5 using a magnetron sputtering device, and a preparation material of the transition layer 1 has a chemical formula of Ni_{0.15}Al_{0.5}Sn_{0.8}O_{1.825}.
Step 13: the nickel oxide hole transport layer 2 with a thickness of 1 nm to 100 nm was prepared by spin-coating a 0.15 M nickel acetylacetonate ethanol solution onto the transition layer 1 at 4000 rpm for 30 s, and subjected to combustion at 400 °C for 30 min.
Step 14, the buffer layer 3 was prepared in a solution combustion manner, and a preparation material of the buffer layer 3 has a chemical formula of NiN_{0.3}0_{0.7}. A solution was prepared by dissolving 29 mg of nickel(II) nitrate hexahydrate (Ni(NO₃)₂·6H₂O) and 3 mg of urea in 1 ml of deionized water, after stirring, the solution was spray-coated onto the nickel oxide hole transport layer 2 to form the buffer layer 3 with a thickness of 0.2 nm to 50 nm, and then the buffer layer 3 was then heated at 400 °C for 30 min under a N₂ atmosphere, and was heated at 200 °C for 10 min in air.
Step 15: the perovskite light-absorbing layer 6 was prepared on the buffer layer 3 in a one-step solution manner.
Step 16: the electron transport layer 7 (PCBM) and a blocking layer (BCP) were coated sequentially on the perovskite light-absorbing layer 6.
Step 17: the back electrode 8 (silver, Ag) was prepared on the electron transport layer 7 and the blocking layer until preparation of the perovskite solar cell was completed.

### Embodiment 2

Referring to FIG. 1, an embodiment of a method for preparing a first type of perovskite solar cell of this application is disclosed, comprising:
Step 21: a glass of the FTO transparent conductive layer 5 was sequentially cleaned by ultrasonic treatment for 30 min each in dishwashing detergent, deionized water, acetone, and isopropanol, and then was dried with N₂, and was subjected to ultraviolet ozone treatment for 10 min.
Step 22, the transition layer 1 was prepared on the FTO transparent conductive layer 5 in a mixing solution manner, and a preparation material of the transition layer 1 has the chemical formula of Cu_{0.05}Al_{0.2}Sn_{0.75}O_{1.85}. A solution was prepared by dissolving 1.4 mg of copper(II) chloride (CuCl₂), 5.4 mg of aluminum chloride (AlCl₃), and 28.5 mg of tin(II) chloride (SnCl₂) in 1 ml of deionized water, and after stirring, the solution was set aside for later use. Then the transition layer 1 with a thickness of 0.2 nm to 50 nm was prepared on the FTO transparent conductive layer 5 by blade coating using the solution, and then the coated transition layer 1 was heated at 500 °C for 1 h in air to obtain the desired transition layer 1.
Step 23: the CuₓO hole transport layer 2 with a thickness of 1 nm to 100 nm was prepared on the transition layer 1 using a magnetron sputtering device.
Step 24: the buffer layer 3 was prepared on the CuₓO hole transport layer 2 using the magnetron sputtering device, and a preparation material of the buffer layer 3 has a chemical formula of Cu_{0.4}Al_{0.6}O_{1.1}.
Step 25: the perovskite light-absorbing layer 6 was prepared on the buffer layer 3 in a one-step solution manner.
Step 26: the electron transport layer 7 (C60) and a blocking layer (acetylacetonate zirconium) were sequentially coated on the perovskite light-absorbing layer 6, where C60 represents fullerene C60.
Step 27: the back electrode 8 (Ag) was prepared on the electron transport layer 7 and the blocking layer until preparation of the perovskite solar cell was completed.

### Embodiment 3

Referring to FIG. 1, an embodiment of a third method for preparing a first type of perovskite solar cell of this application is disclosed, comprising:
Step 31: a glass of the FTO transparent conductive layer 5 was sequentially cleaned by ultrasonic treatment for 30 min each in dishwashing detergent, deionized water, acetone, and isopropanol, and then was dried with N₂, and was subjected to ultraviolet ozone treatment for 10 min.
Step 32: a hydrochloric acid solution containing 0.1 M nickel(III) chloride (NiCl₃) and 0.1 M aluminium chlorid (AlCl₃) was prepared. With iron (Fe) serving as a catalyst, the FTO transparent conductive layer 5 was soaked and treated using the solution for 10 min to 30 min, and the treated transparent conductive layer 5 was heated in air at 500 °C for 30 min to prepare the in-situ formed transition layer 1 on the FTO transparent conductive layer 5, and the transition layer 1 has a chemical formula of Ni_{0.1}Al_{0.11}Sn_{0.8}O_{1.9}.
Step 33: the nickel oxide hole transport layer 2 was prepared by spin-coating a 0.15 M nickel acetylacetonate ethanol solution onto the transition layer 1 at 4000 rpm for 30 s, and subjected to combustion at 400 °C for 30 min.
Step 34, the buffer layer 3 was prepared on the hole transport layer 2 using a CVD device under ammonia (NH₃) and oxygen (O₂) atmospheres, respectively, and a preparation material of the buffer layer 3 has a chemical formula of Ni_{0.9}Al_{0.1}N_{0.1}O_{0.9}.
Step 35: the perovskite light-absorbing layer 6 was prepared on the buffer layer 3 in a one-step solution manner.
Step 36: the electron transport layer 7 (C60) and the electron transport layer 7 (stannic oxide (SnO₂)) were sequentially coated on the perovskite light-absorbing layer 6.
Step 37: the back electrode 8 (copper) was prepared on the electron transport layer 7 until preparation of the perovskite solar cell was completed.

### Embodiment 4

Referring to FIG. 1, an embodiment of a method for preparing a first type of perovskite solar cell of this application is disclosed, comprising:
Step 41: a glass of the FTO transparent conductive layer 5 was sequentially cleaned by ultrasonic treatment for 30 min each in dishwashing detergent, deionized water, acetone, and isopropanol, and then was dried with N₂, and was subjected to ultraviolet ozone treatment for 10 min.
Step 42, the transition layer 1 was prepared on the FTO transparent conductive layer 5 using a CVD device, and a preparation material of the transition layer 1 has a chemical formula of Cu_{0.05}Al_{0.25}N_{0.75}O_{1.85}.
Step 43: the copper(I) thiocyanate (CuSCN) hole transport layer 2 was prepared on the transition layer 1 using a solution manner.
Step 44: a nanocrystalline mixture of copper(I) oxide (Cu₂O) and aluminum oxide (Al₂O₃) was deposited on the CuSCN hole transport layer 2 by blade coating, and the buffer layer 3 (Cu_{0.5}Al_{0.5}O) was prepared.
Step 45: the perovskite light-absorbing layer 6 was prepared on the buffer layer 3 in a one-step solution manner.
Step 46: the electron transport layer 7 (SnO₂) was coated on the perovskite light-absorbing layer 6.
Step 47: the back electrode 8 (Ag) was prepared on the electron transport layer 7 until preparation of the perovskite solar cell was completed.

A composite transport layer of the first type of perovskite solar cell of this application has the following features:
1. Conventional transparent conductive layers, such as the FTO transparent conductive layer, are typically n-type doped. In this application, a gradient-doped transition layer is introduced between the transparent conductive layer and the hole transport layer by incorporating p-type dopants, such as Al, B, and Si, into the transition layer, which creates a doping concentration gradient and energy-level alignment. In addition, the buffer layer replaces organic materials with nitrogen-containing inorganic compounds, which exhibits superior photothermal stability and effectively passivates surface defects of the hole transport layer, thereby enhancing the stability of a second interface between the hole transport layer and the perovskite light-absorbing layer.
2. The perovskite solar cell of this application greatly improves the photo-stability of the perovskite solar cell due to the composite transport layer. For example, when NiOₓ is used as the hole transport layer, nickel (Ni) mainly exists in the forms of Ni²⁺, Ni³⁺, and a small amount of Ni⁴⁺. While Ni³⁺ can enhance charge carrier transport, the presence of Ni³⁺ and higher-valence nickel species can also lead to photocatalytic activity of Ni, thereby affecting the photo-stability of the perovskite solar cell. The transition layer disclosed in this application enables a gradual transition from a hole transport material to a perovskite material, while controlling the proportion of Ni³⁺ and higher-valence Ni species within the transition layer, thereby significantly improving the photo-stability of the perovskite solar cell.

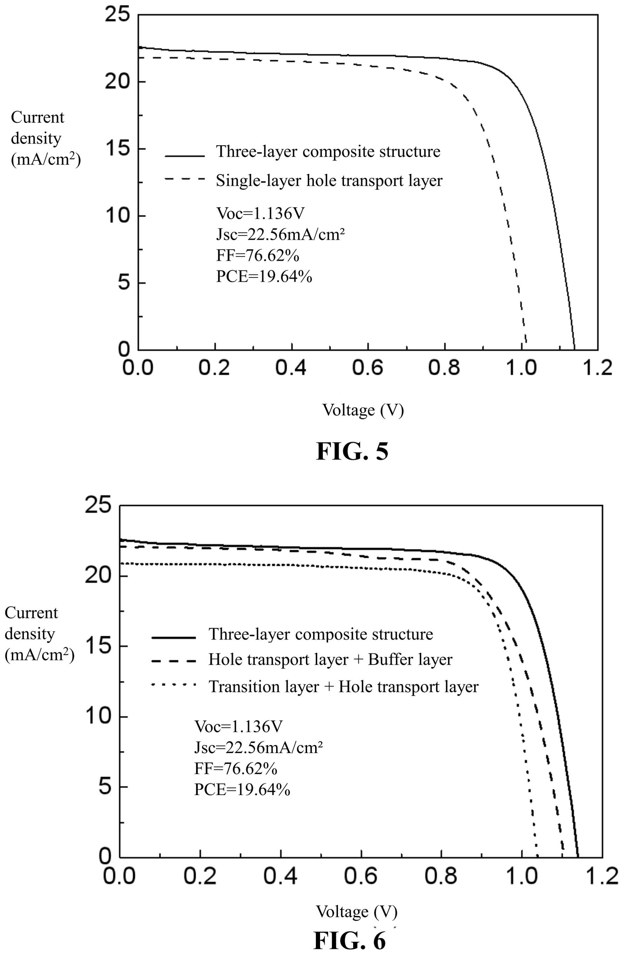

As shown in FIG. 5, the power conversion efficiency curve of the perovskite solar cell (i.e., a three-layer composite structure) prepared in Embodiment 1 of this application, and the power conversion efficiency curve of an existing perovskite solar cell (i.e., a single-layer hole transport layer) including a single-layer hole transport layer prepared in Comparative Example 1 are shown and compared. As can be seen from FIG. 5, the open-circuit voltage of a perovskite solar cell comprising a composite transport layer proposed in this application is significantly improved. The open-circuit voltage of the single-layer hole transport layer reaches 1.014 V, whereas the open-circuit voltage of the three-layer composite structure reaches 1.136 V.

As shown in FIG. 6, the power conversion efficiency curve of a perovskite solar cell comprising a transition layer and a hole transport layer (i.e., transition layer + hole transport layer) in Comparative Example 2, and the power conversion curve of a perovskite solar cell comprising a hole transport layer and a buffer layer (i.e., hole transport layer + buffer layer) in Comparative Example 3 are shown and compared. As can be seen from FIG. 6, compared to the perovskite solar cell prepared in Comparative Example 2, the short-circuit current density (Jsc) and open-circuit voltage (Voc) of the perovskite solar cell prepared in Embodiment 1 are significantly improved, and compared to the perovskite solar cell prepared in Comparative Example 3, the fill factor (FF) of the perovskite solar cell prepared in Embodiment 1 is significantly improved, and the open-circuit voltage (Voc) is further increased, and the power conversion efficiency reaches 19.64%.

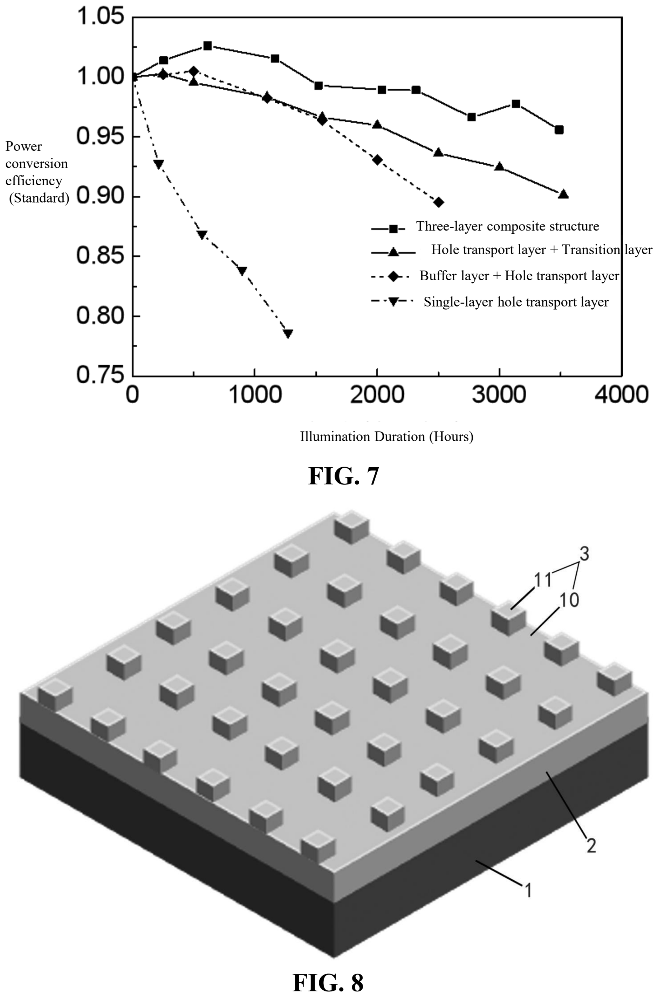

As shown in FIG. 7, the aging experiment curve of the perovskite solar cell (i.e., a three-layer composite structure) prepared in Embodiment 1 of this application, the aging experiment curve of the perovskite solar cell prepared in Comparative Example 1 (i.e., a single-layer hole transport layer), the aging experiment curve of the perovskite solar cell prepared in Comparative Example 2 (i.e., a two-layer structure including a transition layer and a hole transport layer), and the aging experiment curve of the perovskite solar cell prepared in Comparative Example 3 (i.e., a two-layer structure including a hole transport layer and a buffer layer ) are shown and compared. As can be seen from FIG. 7, both the perovskite solar cells prepared in Comparative Example 2 and Comparative Example 3 exhibit improved photo-aging stability compared to the perovskite solar cell prepared in Comparative Example 1. Besides, the perovskite solar cell prepared in Embodiment 1 of this application exhibits less than 5% degradation after 3,500 hours of photo-aging, which is significantly superior to the test results of the perovskite solar cells prepared in Comparative Examples 1 to 3.

### Embodiment 5

Referring to FIG. 2, an embodiment of a method for preparing a second type of perovskite solar cell is disclosed, comprising:
Step 51: a glass of the FTO transparent conductive layer 5 was sequentially cleaned by ultrasonic treatment for 30 min each in dishwashing detergent, deionized water, acetone, and isopropanol, and then was dried with N₂, and was subjected to ultraviolet ozone treatment for 10 min.
Step 52: a solution was prepared by mixing 3-Aminopropyltriethoxysilane with a nanoparticle suspension of Al₂O₃ and SnO₂ (10 wt%, 100 nm) in isopropyl alcohol (IPA) at a volume ratio of 1%. After stirring thoroughly, the solution was irradiated under a 365 nm ultraviolet lamp for 10 min and set aside for later use. The resulting suspension was coated onto the FTO transparent conductive layer 5 by blade coating. After a wet film (a liquid layer formed on the surface of the FTO transparent conductive layer 5 after coating) was heated and annealed, the array transition layer 1 with openings 10 was formed.
Step 53: the nickel oxide hole transport layer 2 with a thickness of 1 nm to 100 nm was prepared by spin-coating a 0.15 M nickel acetylacetonate ethanol solution onto the transition layer 1 at 4000 rpm for 30 s, and subjected to combustion at 400 °C for 30 min.
Step 54, the buffer layer 3 was prepared in a solution combustion manner, and a preparation material of the buffer layer 3 has a chemical formula of NiN_{0.3}0_{0.7}. A solution was prepared by dissolving 29 mg NiNO₃·6H₂O and 3 mg of urea solution in 1 ml of deionized water, after stirring, the solution was set aside for later use. The buffer layer 3 with a thickness of 0.2 mm to 50 mm was prepared on the nickel oxide hole transport layer 2 by spray coating using the solution, and the buffer layer 3 was heated under the N₂ atmosphere at 400 °C for 300 min, and was heated in air at 200 °C for 10 min.
Step 55: the perovskite light-absorbing layer 6 was prepared on the buffer layer 3 in a one-step solution manner.
Step 56: the electron transport layer 7 (PCBM) and a blocking layer (BCP) were sequentially coated on the perovskite light-absorbing layer 6.
Step 57: the back electrode 8 (Ag) was prepared on the electron transport layer 7 and the blocking layer until preparation of the perovskite solar cell was completed.

### Embodiment 6

Referring to FIG. 3 and FIG. 8, an embodiment of a method for preparing a second type of perovskite solar cell of this application is disclosed, comprising:
Step 61: a glass of the FTO transparent conductive layer 5 was sequentially cleaned by ultrasonic treatment for 30 min each in dishwashing detergent, deionized water, acetone, and isopropanol, and then was dried with N₂, and was subjected to ultraviolet ozone treatment for 10 min.
Step 62: the transition layer 1 with a thickness of 0.2 nm to 30 nm was prepared on the FTO transparent conductive layer 5 in a mixing solution manner, and a preparation material of the transition layer 1 has a chemical formula of Cu_{0.05}Al_{0.2}Sn_{0.75}O_{1.85}. A solution was prepared by dissolving 1.4 mg of CuCl₂, 5.4 mg of AlCl₃, and 28.5 mg of SnCl₂ in 1 ml of deionized water, after stirring, the solution was set aside for later user. The transition layer 1 was prepared on the FTO transparent conductive layer 5 by blade coating using the solution, and the transition layer 1 was heated in air at 500 °C for 1 h to obtain the desired transition layer 1.
Step 63: the CuₓO hole transport layer 2 with a thickness of 1 nm to 100 nm was prepared on the transition layer 1 using a magnetron sputtering device.
Step 64: a solution was prepared by mixing vinyltriethoxysilane and a nanoparticle solution of CuₓO and silicon dioxide (SiO₂) (10 wt%, 80 nm) in deionized water at a volume ratio of 1%. After stirring, the resulting solution was heated and stirred at 80 to 100°C for 30 min, then set aside for later use. The prepared suspension was then coated onto the CuₓO hole transport layer 2 by blade coating, and after coating, the CuₓO hole transport layer 2 was annealed to form the array buffer layer 3 with openings 10.
Step 65: the perovskite light-absorbing layer 6 was prepared on the buffer layer 3 in a one-step solution manner.
Step 66: the electron transport layer 7 (C60) and a blocking layer (zirconium acetylacetonate) were sequentially coated on the perovskite light-absorbing layer 6.
Step 67: the back electrode 8 (Ag) was prepared on the electron transport layer 7 and the blocking layer until preparation of the perovskite solar cell was completed.

A composite transport layer of the second type of perovskite solar cell of this application has the following features:
1. Conventional transparent conductive layers, such as the FTO transparent conductive layer, are typically n-type doped. In this application, a gradient-doped transition layer is introduced between the transparent conductive layer and the hole transport layer by incorporating p-type dopants, such as Al, B, and Si, into the transition layer, which creates a doping concentration gradient and energy-level alignment. In addition, the buffer layer replaces organic materials with nitrogen-containing inorganic compounds, which exhibit superior photothermal stability and effectively passivates surface defects of the hole transport layer, thereby enhancing the stability of a second interface between the hole transport layer and the perovskite light-absorbing layer.
2. The perovskite solar cell of this application greatly improves the photo-stability of the perovskite solar cell due to the composite transport layer. For example, when NiOₓ is used as the hole transport layer, nickel (Ni) mainly exists in the forms of Ni²⁺, Ni³⁺, and a small amount of Ni⁴⁺. While Ni³⁺ can enhance charge carrier transport, the presence of Ni³⁺ and higher-valence nickel species can also lead to photocatalytic activity of Ni, thereby affecting the photo-stability of the perovskite solar cell. The transition layer disclosed in this application enables a gradual transition from a hole transport material to a perovskite material, while controlling the proportion of Ni³⁺ and higher-valence Ni species within the transition layer, thereby significantly improving the photo-stability of the perovskite solar cell.
3. Simple formation of openings during the coating of nanoparticles addresses the issue of excessively dense inorganic oxide layer structures, eliminates the influence of the thickness of the transition layer and buffer layer on electron tunneling, and reduces non-radiative recombination at the interface between the perovskite light-absorbing layer and the hole transport layer without impairing charge carrier transport.
4. Inorganic nanocrystals are prone to aggregation during long-term use due to surface defect-induced charge imbalance, which, once aggregation occurs, can negatively affect the stability of the material. However, the adhesive and dispersive effects of the coupling agent can avoid such a phenomenon, thereby enhancing the stability of the material and the device.
5. Since a large number of disordered dangling bonds exist on the surface of inorganic interfaces, the use of the coupling agent can also passivate these surface dangling bonds, thereby suppressing photocatalytic reactions between the inorganic material and the perovskite interface, and further enhancing stability.

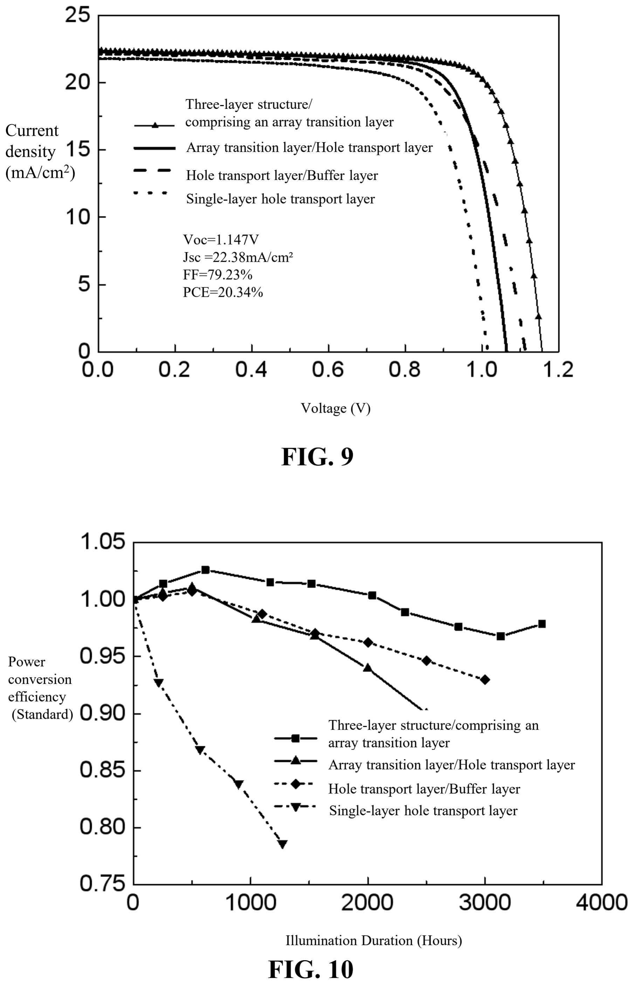

Referring to FIG. 9, a power conversion efficiency curve of a perovskite solar cell (i.e., three-layer structure/comprising an array transition layer) prepared in Embodiment 5 of this application, a power conversion efficiency curve of a perovskite solar cell including a single-layer hole transport layer (i.e., a single hole transport layer) prepared in Comparative Embodiment 1, a power conversion efficiency curve of a perovskite solar cell including an array transition layer and a hole transport layer (i.e., an array transition layer/ hole transport layer) prepared in Comparative Embodiment 4, and a power conversion efficiency curve of a perovskite solar cell including a hole transport layer and a buffer layer (i.e., hole transport layer/buffer layer) prepared in Comparative Embodiment 3 are shown and compared. A difference between the perovskite solar cell prepared in Comparative Embodiment 4 and the perovskite solar cell prepared in Embodiment 6 is that the perovskite solar cell prepared in Comparative Embodiment 4 does not include a buffer layer. A difference between the perovskite solar cell prepared in Comparative Example 3 and the perovskite solar cell prepared in Embodiment 6 is that the perovskite solar cell prepared in Comparative Example 3 does not include a transition layer, and the buffer layer is not in the form of an array. As can be seen from FIG. 9, the open-circuit voltage (1.147 V) and the fill factor (79.23%) of the perovskite solar cell of a three-layer structure prepared in Embodiment 5 of this application are significantly improved compared to the perovskite solar cells prepared in Comparative Examples 1, 4, and 3. At the same time, as can be seen from a comparison of FIG. 9 and FIG. 5, the efficiency of the perovskite solar cell of a three-layer composite structure with an array structure is superior to the perovskite solar cell of the three-layer composite structure without the array structure. Specifically, the open-circuit voltage of the perovskite solar cell of a three-layer composite structure with an array structure is increased from 1.136 V to 1.147 V, the fill factor is increased from 76.62% to 79.23%, and the power conversion efficiency is increased from 19.64% to 20.34% (an increase of approximately 3.6%).

Referring to FIG. 10, a photo-aging curve of a perovskite solar cell (i.e., three-layer structure/comprising an array transition layer) prepared in Embodiment 5 of this application, a photo-aging curve of a perovskite solar cell including a single-layer hole transport layer (i.e., a single hole transport layer) prepared in Comparative Embodiment 1, a photo-aging curve of a perovskite solar cell including an array transition layer and a hole transport layer (i.e., an array transition layer/ hole transport layer) prepared in Comparative Embodiment 4, and a photo-aging curve of a perovskite solar cell including a hole transport layer and a buffer layer (i.e., hole transport layer/buffer layer) prepared in Comparative Embodiment 3 are shown and compared. Compared to the perovskite solar cell prepared in Comparative Example 1, the photostability of the perovskite solar cells prepared in Comparative Examples 4 and 5 is significantly improved. However, the aging test result of the perovskite solar cell prepared in Embodiment 5 of this application is significantly better than the perovskite solar cells prepared in Comparative Examples 1, 4, and 3. The perovskite solar cell prepared in Embodiment 5 exhibits no degradation after 2000 hours of continuous illumination, and the degradation remains below 3% even after 3500 hours. At the same time, a comparison of FIG. 7 and FIG. 10 reveals that the photostability of the perovskite solar cell of a three-layer composite structure with an array structure is also superior to the perovskite solar cell of a three-layer composite structure without an array structure. After 3500 hours of illumination, the degradation is reduced from approximately 5% to less than 3%.

The above descriptions are merely preferred embodiments of this application and are not intended to limit the scope thereof. Any modifications, equivalent substitutions, or improvements made within the spirit and principles of this application shall be included within the scope of protection of this application.

## Claims

1. A composite transport layer, comprising a transition layer, a hole transport layer, and a buffer layer sequentially stacked along a light incident direction, wherein a preparation material of the transition layer is NiₓA_{y}Si_{z}SnₘOₙ or CuₓA_{y}Si_{z}SnₘOₙ, x>0, y ≥ 0, z≥0, m≥0, n>0, A is aluminum (Al) or boron (B), and the preparation material of the transition layer at least includes any one of A, silicon (Si), or tin (Sn); a preparation material of the hole transport layer is any one of NiOₓ, CuₓO, or CuSCN; and a preparation material of the buffer layer is NiₐE_{b}N_{c}O_{d} or CuₐE_{b}N_{c}O_{d}, a >0, b≥0, c >0, d≥0, and E is any one of Al, B, Si, zinc (Zn), cobalt (Co), or zirconium (Zr).

2. A composite transport layer, comprising a transition layer, a hole transport layer, and a buffer layer sequentially stacked along a light incident direction, wherein a preparation material of the transition layer is NiₓA_{y}Si_{z}SnₘOₙ or CuₓA_{y}Si_{z}SnₘOₙ, x>0, y ≥ 0, z≥0, m≥0, n>0, A is aluminum (Al) or boron (B), and the preparation material of the transition layer at least includes any one of A, Si, or Sn; a preparation material of the hole transport layer is any one of NiOₓ, CuₓO, or CuSCN; and a preparation material of the buffer layer is NiₐE_{b}N_{c}O_{d} or CuₐE_{b}N_{c}O_{d}, a >0, b≥0, c >0, d≥0, and E is any one of Al, B, Si, Zn, Co, or Zr; the preparation material of the transition layer and/or the buffer layer is added and doped with a coupling agent to obtain a corresponding array transition layer and/or array buffer layer containing the coupling agent, a thin film prepared from the array transition layer and/or array buffer layer doped with the coupling agent includes a plurality of array molecular groups containing the coupling agent that are discretely arranged and a plurality of openings separating two adjacent array molecular groups among the plurality of array molecular groups, and each of the plurality of opening communicates an upper surface and lower surface of the thin film in which it is located, respectively; and the coupling agent is any one of a silane coupling agent, a titanate coupling agent, an aluminate coupling agent, a phosphate coupling agent, or a borate coupling agent.

3. The composite transport layer of claim 2, wherein an addition amount of the coupling agent is in a range of 0.5% to 5% of a volume of a nanoparticle suspension for preparing the transition layer and/or the buffer layer, and a concentration of the nanoparticle suspension is in a range of 0.1wt.% to 10wt.%.

4. The composite transport layer of claim 2, wherein a length of each of the plurality of openings is in a range of 10 nm to 200 nm.

5. The composite transport layer of claim 1 or 2, wherein a thickness of the transition layer is in a range of 0.2 nm to 30 nm, a thickness of the hole transport layer is in a range of 1 nm to 100 nm, and a thickness of the buffer layer is in a range of 0.2 nm to 50 nm.

6. A perovskite solar cell, comprising a transparent conductive layer, a perovskite light-absorbing layer, an electron transport layer, and a back electrode stacked sequentially, wherein the composite transport layer of claim 1 is arranged between the transparent conductive layer and the perovskite light-absorbing layer, a transition layer of the composite transport layer is in conformal contact with the transparent conductive layer, and a buffer layer of the composite transport layer is in conformal contact with the perovskite light-absorbing layer.

7. A perovskite solar cell, comprising a transparent conductive layer, a perovskite light-absorbing layer, an electron transport layer, and a back electrode stacked sequentially, wherein the composite transport layer of claim 2 is arranged between the transparent conductive layer and the perovskite light-absorbing layer, a transition layer of the composite transport layer is in conformal contact with the transparent conductive layer, and a buffer layer of the composite transport layer is in conformal contact with the perovskite light-absorbing layer.

8. A method for preparing the perovskite solar cell of claim 6, comprising:
step 1, cleaning and performing ultraviolet ozone treatment on the transparent conductive layer;
step 2, preparing the transition layer on the transparent conductive layer in a vapor phase manner or a liquid phase manner, wherein the vapor phase manner is to prepare the transition layer using any one of an atomic layer deposition (ALD) device, a chemical vapor deposition (CVD) device, a magnetron sputtering device, an electron-beam evaporation device, or a thermal evaporation device, and the liquid phase manner is to prepare the transition layer by any one of a solution mixing manner, a hydrothermal manner, a chemical bath deposition (CBD) manner, or an in-situ doping manner;
step 3, preparing the hole transport layer on the transition layer using any one of the ALD device, the CVD device, the magnetron sputtering device, the electron-beam evaporation device, or the thermal evaporation device, or preparing the hole transport layer by any one of blade coating, slot-die coating, or spray coating;
step 4, preparing the buffer layer on the hole transport layer in the vapor phase manner or the liquid phase manner, wherein the vapor phase manner is to prepare the buffer layer using any one of the ALD device, the CVD device, the magnetron sputtering device, the electron-beam evaporation device, or the thermal evaporation device, and the liquid phase manner is to prepare the buffer layer by any one of the solution mixing manner, the hydrothermal manner, the CBD manner, or the in-situ doping manner; and
step 5, preparing the perovskite light-absorbing layer, the electron transport layer, and the back electrode on the buffer layer sequentially until preparation of the perovskite solar cell is completed.

9. A method for preparing the perovskite solar cell of claim 7, comprising:
step I, cleaning and performing ultraviolet ozone treatment on the transparent conductive layer;
step II, obtaining a first composite precursor solution by mixing the coupling agent with a material solution for preparing the transition layer, performing ultraviolet irradiation treatment or high-temperature treatment on the first composite precursor solution, and then coating the treated first composite precursor solution on the transparent conductive layer, and annealing and drying the treated first composite precursor solution on the transparent conductive layer to obtain an array transition layer;
step III, preparing the hole transport layer on the transition layer using any one of an ALD device, a CVD device, a magnetron sputtering device, an electron-beam evaporation device, or a thermal evaporation device, or preparing the hole transport layer by any one of blade coating, slot-die coating, or spray coating;
step IV, preparing the buffer layer on the hole transport layer in a vapor phase manner or a liquid phase manner, wherein the vapor phase manner is to prepare the buffer layer using any one of the ALD device, the CVD device, the magnetron sputtering device, the electron-beam evaporation device, or the thermal evaporation device, and the liquid phase manner is to prepare the buffer layer by any one of a solution mixing manner, a hydrothermal manner, a CBD manner, or an in-situ doping manner; and
step V, preparing the perovskite light-absorbing layer, the electron transport layer, and the back electrode on the buffer layer sequentially until preparation of the perovskite solar cell is completed.

10. A method for preparing the perovskite solar cell of claim 7, comprising:
step 1, cleaning and performing ultraviolet ozone treatment on the transparent conductive layer;
step 2, preparing the transition layer on the transparent conductive layer in a vapor phase manner or a liquid phase manner, wherein the vapor phase manner is to prepare the transition layer using any one of an ALD device, a CVD device, a magnetron sputtering device, an electron-beam evaporation device, or a thermal evaporation device, and the liquid phase manner is to prepare the transition layer by any one of a solution mixing manner, a hydrothermal manner, a CBD manner, or an in-situ doping manner;
step 3, preparing the hole transport layer on the transition layer using any one of the ALD device, the CVD device, the magnetron sputtering device, or the electron-beam evaporation device, and the thermal evaporation device, or preparing the hole transport layer on the transition layer by any one of blade coating, slot-die coating, or spray coating;
step 4, obtaining a second composite precursor solution by mixing the coupling agent with a material solution for preparing the buffer layer, performing ultraviolet irradiation treatment or high-temperature treatment on the second composite precursor solution, and then coating the treated second composite precursor solution on the hole transport layer, and annealing and drying the treated second composite precursor solution on the hole transport layer to obtain an array buffer layer; and
step 5, preparing the perovskite light-absorbing layer, the electron transport layer, and the back electrode on the buffer layer sequentially until preparation of the perovskite solar cell is completed.
